# EUROPEAN PATENT APPLICATION

(11) **EP 2 453 484 A1**
(43) Date of publication of application: **16.05.2012**
(21) Application number: 09847051.1
(22) Date of filing: 06.07.2009
(51) Int. Cl.: H01L 31/0352, H01L 31/075

(54) **PHOTOELECTRIC CONVERSION ELEMENT**

(71) Applicant: Toyota Jidosha Kabushiki Kaisha, Toyota-shi, Aichi 471-8571 (JP)
(72) Inventor: NOMURA, Hidefumi, Toyota-shi Aichi 471-8571 (JP); FUKADA, Yoshiki, Toyota-shi Aichi 471-8571 (JP); NAGASHIMA, Tomonori, Toyota-shi Aichi 471-8571 (JP)
(74) Representative: Winter, Brandl, Fürniss, Hübner, Röss, Kaiser, Polte - Partnerschaft
(86) International application number: PCT/JP2009/062300
(87) International publication number: WO 2011/004446

(57) **Abstract**

A main object of the present invention is to provide a photoelectric conversion device which is capable of improving the photoelectric conversion efficiency. The invention comprises: a semiconductor; and a layer being disposed inside the semiconductor and having metal nanoparticles.

## Description

### Technical Field

The present invention relates to a photoelectric conversion device; particularly relates to a photoelectric conversion device employing the optical electric-field enhancing effect by localized surface plasmon resonance.

### Background Art

A solar cell has advantages that the volume of carbon dioxide emissions per electric-generating capacity is small and it is not necessary to use fuel for electric generation. So, various types of researches about solar cells have been developed. At present, among the solar cells in practical use, a mono-junction solar cell having a pair of p-n junction and employing a single-crystal silicon or a polycrystal silicon is a main stream. However, since the theoretical limitation of the photoelectric conversion efficiency of the mono-junction solar cell (hereinafter, referred to as "theoretical marginal limitation".) is only about 30%, new methods (means) for further improving the theoretical marginal limitation have been studied.

One of the new methods (means) which have been studied so far is a solar cell employing a quantum structure of semiconductor. Known examples of the quantum structure used for this type of solar cell may be quantum dot, quantum well, and quantum wire. By employing quantum structure, it is possible to absorb solar-spectrum having a certain band which could not be absorbed by the conventional solar cells. Therefore, according to the solar cell employing the quantum structure, it is assumed that the theoretical marginal limitation can be improved up to 60% or more.

Some of the arts related to such a solar cell (including a photovoltaic device and a photoelectric conversion device) or arts applicable for the solar cell have been disclosed. For example, Patent document 1 discloses a surface Plasmon enhancing photovoltaic device which comprises a surface irradiated by an incident light and a surface not being irradiated by an incident light, at least one of the surface irradiated by an incident light and the surface not being irradiated by an incident light comprises: a first metal electrode having alignment of aperture which has a enhancing property generating resonance interaction between the incident light and the surface plasmon on the surface; and a second electrode disposed at an interval from the first metal electrode. Patent document 2 discloses a photoelectric conversion device, in which (as at least a part of the constituent elements) a mixture at least containing: a multiphoton absorption organic material; metal fine particles for generating the localized plasmon enhancing field; and a dispersant is used. Patent document 3 discloses a composite dielectric material obtained by coating the whole or a part of the surfaces of substantially spherical metallic grains having an average grain size of 0.1 to 10 µm with a dielectric layer and dispersing the coated grains into at least one kind of resin. Patent document 4 discloses an insulating magnetic metal particle and a manufacturing method of an insulating magnetic material. Patent document 5 discloses a solar cell comprising a pin-structure, wherein the i-layer as the photodetecting layer includes a three-dimensionally confined quantum dot, so that the energy band structure of the quantum dot and the barrier layer surrounding it form a type II.

### Citation List

### Patent Literatures

Patent document 1: Japanese Patent Application Laid-Open (JP-A) No. 2002-076410
Patent document 2: JP-A No. 2008-122439
Patent document 3: JP-A No. 2001-303102
Patent document 4: JP-A No. 2008-041961
Patent document 5: JP-A No. 2006-114815

### Summary of the Invention

### Technical Problems

According to Patent document 1, since the invention uses a resonance interaction with the surface plasmon, it is possible to encourage the light absorption; thereby it is assumed that the photoelectric conversion efficiency can be improved. However, by the mode using the resonance interaction with the surface plasmon on the surface as shown in Patent document 1, light absorption promoting effect tends to be insufficient. While, according to the art shown in Patent document 2, since metal fine particles for generating the localized plasmon enhancing field are three-dimensionally-arranged; presumably, the art of Patent document 2 can obtain the light absorption promoting effect easily compared with the art of Patent document 1. Nevertheless, in the art of Patent document 2, the metal fine particles are dispersed in the electrolyte, so it is difficult to disperse the metal fine particles homogeneously; thereby, the improving effect of the photoelectric conversion efficiency tends to decline, which is problematic. These problems are difficult to be solved even by the combination of Patent documents 1 to 5.

Accordingly, an object of the present invention is to provide a photoelectric conversion device capable of improving the photoelectric conversion efficiency.

### Solution to Problems

In order to solve the above problems, the present invention has the following means. In other words, the first aspect of the present invention is a photoelectric conversion device comprising a layer, which comprise a semiconductor and metal nanoparticles disposed inside the semiconductor.

The term "metal nanoparticle" means a metal nanoparticle preferably having a diameter of 2 nm or more and 10 nm or less. Examples of the metal constituting the metal nanoparticles may be Au, Ag, and Pt.

In the first aspect of the invention, at least a part of the surface of the metal nanoparticles is preferably coated by an insulator.

In the first aspect of the invention, the photoelectric conversion device comprises: a p-layer; an n-layer; a first electrode connected to the p-layer; and a second electrode connected to the n-layer, wherein a semiconductor located between the first electrode and a depletion layer formed by connecting the p-layer and the n-layer and/or a semiconductor located between the depletion layer and the second electrode preferably contain a larger number of the metal nanoparticles than the depletion layer itself.

Here, the "first electrode" means an electrode being located outside the p-layer (i.e. when the pn junction interface side is the front face of the p-layer, the first electrode locates at the back face side of the p-layer.) when seen from the pn junction interface (when an i-layer exists between the p-layer and the n-layer, the first electrode is the "i-layer". Below, it is the same.). The "second electrode" means an electrode located outside the n-layer (i.e. when the pn junction interface side is the back face of the n-layer, the second electrode locates at the front face side of the n-layer.) when seen from the pn junction interface. When a pn junction is formed by directly connecting the p-layer and the n-layer, the "semiconductor located between the first electrode and the depletion layer" include a part of the p-layer which is the region where depleted region has been removed from the p-layer. When the i-layer is arranged between the p-layer and the n-layer, the "semiconductor located between the first electrode and the depletion layer" includes at least a part of the p-layer. Further, when pn junction is formed by directly connecting the p-layer and the n-layer, the "semiconductor located between the depletion layer and the second electrode" includes a part of the n-layer which is the region where depleted region has been removed from the n-layer. Still further, when the i-layer is arranged between the p-layer and the n-layer, the "semiconductor located between the depletion layer and the second electrode" includes at least a part of the n-layer.

The second aspect of the present invention is a photoelectric conversion device comprising: a quantum structure portion; and a semiconductor layer arranged around the quantum structure portion, the constituent material of the quantum structure portion comprising the semiconductor, and the metal nanoparticles being arranged inside the quantum structure portion and/or inside the semiconductor layer.

Here, the "quantum structure portion" means, for example, quantum dot, quantum well, and quantum wire. The "semiconductor layer arranged around the quantum structure portion" means a semiconductor as a base material in which the quantum structure portion is buried when the quantum structure portion is buried in a semiconductor. On the other hand, when the quantum structure portions and semiconductors which do not constitute the quantum structure portion are alternately laminated, the "semiconductor layer arranged around the quantum structure portion" means a semiconductor which is laminated between the adjacent quantum structure portions and does not constitute the quantum structure portion.

In the second aspect of the invention, at least a part of the surface of the metal nanoparticle is preferably coated by an insulator.

Moreover, in the second aspect of the invention, when the metal nanoparticles are arranged inside the semiconductor layer, the distance between the quantum structure portion and at least a part of the metal nanoparticles arranged inside the semiconductor layer is preferably less than or equal to the diameter of the metal nanoparticle.

Further, in the first and second aspects of the invention, when the diameter of the metal nanoparticle being arranged in a region located at a distance of D1 from the light receiving face is R1 and the diameter of the metal nanoparticle being arranged in a region located at a distance of D2 which is longer than D1 from the light receiving face is R2, the relation between R1 and R2 is preferably: R2 > R1.

### Effects of the Invention

According to the first aspect of the invention, since the metal nanoparticle is disposed inside the semiconductor, it is possible to three-dimensionally and homogenously arrange the metal nanoparticle. Therefore, compared with the case where the metal nanoparticle is disposed only on the front face of the solar cell, it is possible to generate localized surface plasmon resonance in many regions of the semiconductors. By generating localized surface plasmon resonance in many regions, it is possible to enhance the optical electric-field in many regions of the semiconductor; so, according to the present invention, it is possible to provide a photoelectric conversion device which is capable of improving the photoelectric conversion efficiency.

In addition, in the first aspect of the invention, when at least a part of the surface of the metal nanoparticle is coated by the insulator, it is possible to prevent metal nanoparticle from capturing electrons and holes (hereinafter, electrons and holes are referred to as "carrier" as a whole.) generated by the light irradiation. Thereby, it is possible to easily improve the photoelectric conversion efficiency.

Moreover, in the first aspect of the invention, when the region other than the depletion layer contains a larger number of metal nanoparticles than the depletion layer itself, it is possible to prevent disappearance of carrier caused by recombination and also possible to prevent the metal nanoparticle from capturing carrier or making the carriers scatter. Thereby, it is possible to easily improve the photoelectric conversion efficiency.

According to the second aspect of the invention, the metal nanoparticles are arranged inside the quantum structure portion and/or in the semiconductor layer disposed at the periphery thereof. By arranging the metal nanoparticles inside and/or at the vicinity of the quantum structure portion, it is possible to enhance the optical electric-field in the quantum structure portion. Moreover, by arranging the metal nanoparticles in the semiconductor layer disposed at the periphery of the quantum structure portion, it is possible to enhance the optical electric-field in the semiconductor layer. Therefore, according to the second aspect of the invention, it is possible to provide a photoelectric conversion device which is capable of improving the photoelectric conversion efficiency.

Further, in the second aspect of the invention, when at least a part of the surface of the metal nanoparticle is coated by the insulator, it is possible to prevent the metal nanoparticles from capturing the carrier generated by light irradiation. Thereby, it is possible to easily improve the photoelectric conversion efficiency.

Presumably, the optical electric-field enhancing effect by the localized surface plasmon resonance is expressed up to a distance equivalent to the diameter of the metal nanoparticle. Therefore, according to the second aspect of the invention, when the distance between the quantum structure portion and at least a part of the metal nanoparticle arranged inside the semiconductor layer is less than or equal to the diameter of the metal nanoparticle, it is possible to easily enhance the optical electric-field not only in the semiconductor layer but also in the quantum structure portion. Thereby, it is possible to easily improve the photoelectric conversion efficiency.

In the first and second aspects of the invention, by arranging smaller metal nanoparticles in a region located at a shorter distance from the light receiving face, it is possible to enhance short-wavelength optical electric-field in a region (which can easily absorb a short wavelength light) located at a shorter distance from the light receiving face. Moreover, by arranging larger metal nanoparticles in a region located at a longer distance from the light receiving face, it is possible to enhance long-wavelength optical electric-field in a region (which can easily absorb a long wavelength light) located at a longer distance from the light receiving face. Thereby, it is possible to easily improve the photoelectric conversion efficiency.

### Brief Description of the Drawings

Fig. 1 is a cross-sectional view illustrating an example of a solar cell 10;
Fig. 2 is a cross-sectional view illustrating an example of a solar cell 20;
Fig. 3 is a cross-sectional view illustrating an example of a solar cell 30;
Fig. 4 is a cross-sectional view illustrating an example of a solar cell 40;
Fig. 5 is a cross-sectional view illustrating an example of a solar cell 50; and
Fig. 6 is a cross-sectional view illustrating an example of a solar cell 60.

### List of Reference Numerals

- 1: nanoparticle
- 1a: metal nanoparticle
- 1b: insulator
- 10: solar cell
- 11: p-layer
- 12: n-layer
- 13: antireflective-and-transparent conductive film
- 14: front-face electrode (second electrode)
- 15: back-face electrtode (first electrode)
- 20: solar cell
- 21: p-layer
- 22: n-layer
- 23: depletion layer
- 30: solar cell
- 31: p-layer
- 32: n-layer
- 33: i-layer
- 40: solar cell
- 41: i-layer
- 42: quantum structure portion
- 42a: wet layer
- 42b: quantum dot
- 43: interlayer (semiconductor layer)
- 50: solar cell
- 51: i-layer
- 52: interlayer (semiconductor layer)
- 60: solar cell
- 61: i-layer
- 62: quantum structure portion
- 62a: wet layer
- 62b: quantum dot

### Description of Modes for Carrying out the Invention

Hereinafter, a case in which the present invention is applied to a solar cell will be described with reference to the drawings. It should be noted that the embodiments shown below are examples of the present invention, so that the invention is not limited by the modes.

### 1. The first embodiment

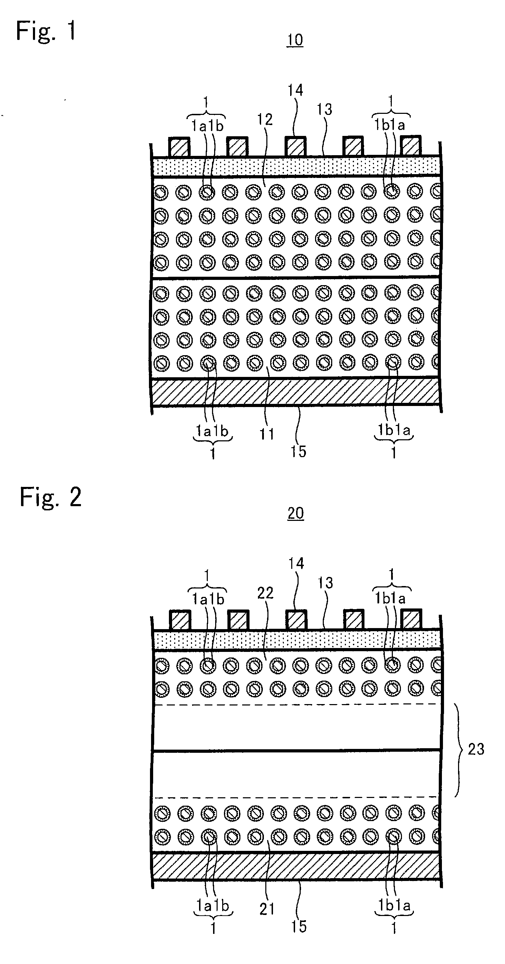

Fig. 1 is a cross-sectional view illustrating an example of a solar cell 10 according to the first embodiment of the present invention. In order to make the understanding of the present invention easier, in Fig. 1, thickness of the p-layer 11 and the n-layer 12 is increased. As shown in Fig. 1, the solar cell 10 comprises: a p-layer 11; an n-layer 12; an antireflective-and-transparent conductive film 13 disposed on the surface of the n-layer 12; front-face electrodes 14 arranged in a comb-shaped manner on the surface of the antireflective-and-transparent conductive film 13; and a back-face electrode 15 disposed on the back face of the p-layer 11. The nanoparticles 1, 1, ... are three-dimensionally and homogeneously arranged inside all over the p-layer 11 and the n-layer 12, including a depletion layer (formed by pn junction). The p-layer 11 is formed of a P-type semiconductor; and the n-layer 12 is formed of an N-type semiconductor. The nanoparticle 1 comprises: a metal nanoparticle 1a; and an insulator 1b coating the entire surface of the metal nanoparticle 1a.

When a light is irradiated to the solar cell 10, a light of which reflection is inhibited by the antireflective-and-transparent conductive film 13 enters into the n-layer 12 and the p-layer 11. When the light enters into the n-layer 12 and the p-layer 11, the light is absorbed in these layers and then carriers (i.e. electron and hole) are produced. As for the produced carriers, due to the internal electric field generated by the p-layer 11 and the n-layer 12, the electron moves toward the front-face electrode 14 and the hole moves toward the back-face electrode 15. Inside the p-layer 11 and the n-layer 12, nanoparticles 1, 1, ... each including a metal nanoparticle 1a (hereinafter, referred to as simply "nanoparticles 1, 1, ...".) are arranged. So, when the light entered into the p-layer 11 and the n-layer 12 reaches the nanoparticles 1, 1, ..., by the localized surface plasmon resonance, the optical electric-field is locally enhanced at the vicinity of the nanoparticles 1, 1, ... (for instance, it is the region located at a distance of 100 nm or less away from the nanoparticles 1, 1, .... Below, it is the same.) arranged inside the p-layer 11 and the n-layer 12. In the solar cell 10, since the nanoparticles 1, 1, ... are three-dimensionally and homogeneously arranged inside the p-layer 11 and the n-layer 12, compared with the case where the nanoparticles 1, 1, ... are arranged only on the surface of the p-layer 11 and the n-layer 12, it is possible to enhance the optical electric-field in many regions of both the P-type semiconductor constituting the p-layer 11 and the N-type semiconductor constituting the n-layer 12. When the optical electric-field generated by the light entered into the semiconductor is enhanced, it is possible to produce many carriers in the semiconductor; thereby, it is possible to improve the photoelectric conversion efficiency. Hence, according to the invention, it is possible to provide a solar cell 10 which is capable of improving the photoelectric conversion efficiency.

In this way, according to the invention, the optical electric-field generated by the light entered into the p-layer 11 and the n-layer 12 can be enhanced by the nanoparticles 1, 1, ... three-dimensionally arranged inside the p-layer 11 and the n-layer 12. So, even when the thickness of the p-layer 11 and the n-layer 12 is set at a thickness equivalent to that of the conventional solar cell (i.e. a solar cell which does not have metal nanoparticles), it is possible to improve the photoelectric conversion efficiency than the conventional solar cell.

In addition, in the nanoparticles 1, 1, ... arranged inside the p-layer 11 and the n-layer 12, since the entire surface of each metal nanoparticle 1a is coated by the insulator 1b, it is possible to prevent the conductive metal nanoparticles 1a, 1a, ... from capturing the carriers produced in the p-layer 11 and the n-layer 12. By providing an embodiment where the carriers are not captured by the metal nanoparticles 1a, 1a, ..., it is possible to move many carriers toward the front-face electrode 14 and the back-face electrode 15. Therefore, according to the invention, it is possible to provide a solar cell 10 which is capable of improving the photoelectric conversion efficiency.

In the solar cell 10, the constituent material of the p-layer 11 may be a known P-type semiconductor, such as a P-type GaAs in which beryllium is doped for setting the density of the hole at 1 x 18 cm⁻³. The thickness of the p-layer 11 (i.e. thickness in the upper-and-lower direction of Fig. 1; below, it is the same.) may be 3.5 nm. The constituent material of the n-layer 12 may be a known N-type semiconductor, such as a N-type GaAs in which silicon is doped for setting the density of the electron at 1 × 18 cm⁻³. Thickness of the n-layer 12 may be 0.1 µm. Examples of the constituent material for the antireflective-and-transparent conductive film 13 include a known material such as MgF₂ and TiO₂. Thickness of the antireflective-and-transparent conductive film 13 may be 0.1 µm. Examples of the constituent material for the front-face electrode 14 and the back-face electrode 15 include a known material such as Ag. Thickness of the front-face electrode 14 may be 0.1-10 µm; thickness of the back-face electrode 15 may be 0.1-2 µm. Examples of the constituent material for the metal nanoparticle 1a may be Au, Ag, and Pt. Moreover, when the metal nanoparticle 1a is formed of Ag, the insulator 1b may be, for example, AgO produced by oxidizing Ag. When the metal nanoparticle 1a is formed of Pt, the insulator 1b may be, for example, PdO. The diameter of the metal nanoparticle 1a may be 2-100 nm; for example, when the diameter of the metal nanoparticle 1a is 2 nm, thickness of the insulator 1b may be 1 nm.

An example of the method for producing the above solar cell 10 will be described below. To produce the solar cell 10, first of all, the back-face electrode 15 is formed on a surface of a substrate (not shown) by a known method such as vapor deposition and sputtering method. When formation of the back-face electrode 15 is completed, a P-type semiconductor is deposited on the surface of the back-face electrode 15 by Chemical Vapor Deposition (CVD) method or Molecular Beam Epitaxy (MBE) method. After depositing the P-type semiconductor in this way, the back-face electrode 15 on which the P-type semiconductor is deposited is taken out from the CVD device or MBE device; then, an aqueous solution in which core-shell metal nanoparticles (i. e. metal nanoparticles having a platinum core of which surface is coated by palladium) are dispersed (For example, there may be "Pt/Pd (core-shell) PVP-based solution manufactured by Tanaka Kikinzoku Kogyo K.K.; hereinafter, referred to as "metal nanoparticle solution".) is homogeneously applied to the surface of the P-type semiconductor by using spin coater. After applying the metal nanoparticle solution, by evaporating the moisture in a furnace with oxygen atmosphere, nanoparticles 1, 1, ... each having metal nanoparticle 1a (Pt) of which surface is coated by the insulator 1b (PdO) are arranged on the surface of the P-type semiconductor. After arranging the nanoparticles 1, 1, ... in this way, the back-face electrode 15 on which the nanoparticles 1, 1, ... and the P-type semiconductor are arranged is reinstalled in the CVD device or the MBE device; then, the P-type semiconductor is deposited on the surface of the nanoparticles 1, 1, ... and the P-type semiconductor by CVD method or MBE method. Later, by arranging the nanoparticles 1, 1, ... and depositing the P-type semiconductor repeatedly, a p-layer 11 in which the nanoparticles 1, 1, ... are arranged can be formed on the surface of the back-face electrode 15. When formation of the p-layer 11 is completed in this way, except for using an N-type semiconductor instead of using the P-type semiconductor, in the same manner as the method for forming the p-layer 11, the n-layer 12 in which the nanoparticles 1, 1, ... are arranged are formed on the surface of the p-layer 11. After forming the n-layer 12, the antireflective-and-transparent conductive film 13 is formed continuously on the surface of the n-layer 12 by CVD method or MBE method. By using a known method such as vapor deposition or sputtering method, the front-face electrode 14 is formed on the surface of the antireflective-and-transparent conductive film 13, to produce the solar cell 10.

### 2. The second embodiment

Fig. 2 is a cross-sectional view illustrating an example of the solar cell 20 according to the second embodiment of the invention. In order to make the understanding of the present invention easier, in Fig. 2, thickness of the p-layer 21 and the n-layer 22 is increased. In Fig. 2, the same elements shown in the solar cell 10 are given the same reference numerals as shown in Fig. 1 and the description is not repeated.

As shown in Fig. 2, the solar cell 20 comprises: a p-layer 21 constituted by a P-type semiconductor; an n-layer 22 constituted by an N-type semiconductor; an antireflective-and-transparent conductive film 13 disposed on the surface of the n-layer 22; a front-face electrodes 14 arranged in a comb-shaped manner on the surface of the antireflective-and-transparent conductive film 13; and a back-face electrode 15 disposed on the back face of the p-layer 21. Inside the p-layer 21 and the n-layer 22, nanoparticles 1, 1, ... are three-dimensionally and homogeneously arranged only at portions excluding the depletion layer 23 formed by pn junction (hereinafter, referred to as "depletion layer region 23".).

When a light is irradiated to the solar cell 20, a light of which reflection is inhibited by the antireflective-and-transparent conductive film 13 enters into the n-layer 22 and the p-layer 21. When the light enters into the n-layer 22 and the p-layer 21, the light is absorbed in these layers and then carriers are produced. As for the produced carriers, due to the internal electric field generated by the p-layer 21 and the n-layer 22, the electron moves toward the front-face electrode 14 and the hole moves toward the back-face electrode 15. Inside the p-layer 21 and the n-layer 22, nanoparticles 1, 1, ... are arranged only at portions excluding the depletion layer region 23. So, when the light entered into the p-layer 21 and the n-layer 22 reaches the nanoparticles 1, 1, ..., by the localized surface plasmon resonance, the optical electric-field is locally enhanced at the vicinity of the nanoparticle 1, 1, .... In the solar cell 20, since the nanoparticles 1, 1, ... are three-dimensionally and homogeneously arranged inside the p-layer 21 and the n-layer 22, compared with the case where the nanoparticles 1, 1, ... are arranged only on the surface of the p-layer 21 and the n-layer 22, it is possible to enhance the optical electric-field in many regions of both the P-type semiconductor constituting the p-layer 21 and the N-type semiconductor constituting the n-layer 22. When the optical electric-field generated by the light entered into the semiconductor is enhanced, it is possible to produce many carriers in the semiconductor; thereby, it is possible to improve the photoelectric conversion efficiency. Hence, according to the invention, it is possible to provide a solar cell 20 which is capable of improving the photoelectric conversion efficiency.

As above, in the solar cell 20, the nanoparticles 1, 1, ... are arranged only at the n-layer 22 except for the depletion layer region 23 and the p-layer 21 except for the depletion layer region 23. In a part of the p-layer 21 and a part of the n-layer 22 respectively constituting the depletion layer region 23, the nanoparticle 1, 1, ... are not arranged. By not arranging the nanoparticle 1, 1, ... in the depletion layer region 23 generating many photogenerated carriers, it is possible to prevent the metal nanoparticles 1, 1, ... from capturing or scattering the carriers before the carriers reach the front-face electrode 14 and the back-face electrode 15. Thereby, it is possible to reduce the moving distance of the carrier before reaching the front-face electrode 14 and the back-face electrode 15. Moreover, by the embodiment, it is also possible to prevent the carriers from disappearing by the recombination. By reducing the carriers' moving distance and preventing the carriers from disappearing by the recombination, it is possible to improve the photoelectric conversion efficiency. Accordingly, by the solar cell 20, it is possible to easily improve the photoelectric conversion efficiency than the solar cell 10.

In the solar cell 20, the p-layer 21 may be constituted by the same material as that of the p-layer 11 of the solar cell 10; the thickness of the p-layer 21 (i.e. thickness in the upper-and-lower direction of Fig. 2; below, it is the same.) may be 3. 5 nm. The n-layer 22 may be constituted by the same material as that of the n-layer 12 of the solar cell 10; the thickness of the n-layer 22 may be 0.1 µm. A part of the p-layer 21 constituting the depletion layer region 23 can be formed by, for example, depositing the P-type semiconductor by CVD method or MBE method. The area of the p-layer 21 where the nanoparticles 1, 1, ... are arranged can be formed in the same manner as the method of forming the p-layer 11. A part of the n-layer 22 constituting the depletion layer region 23 can be formed by, for example, depositing the N-type semiconductor by CVD method or MBE method. The area of the n-layer 22 where the nanoparticles 1, 1, ... are arranged can be formed in the same manner as the method of forming the n-layer 12. Other than these, the antireflective-and-transparent conductive film 13, the front-face electrode 14, and the back-face electrode 15 can be formed in the same manner as the method of producing the solar cell 10.

### 3. The third embodiment

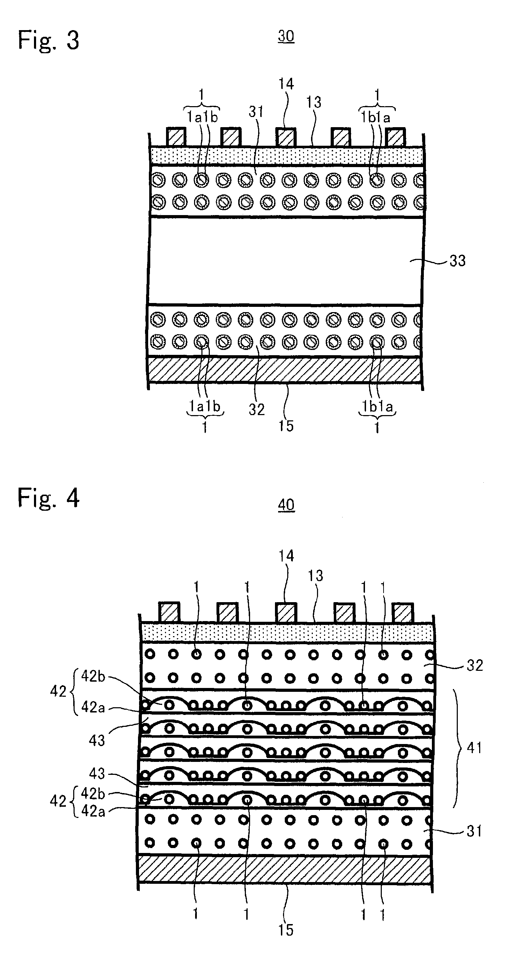

Fig. 3 is a cross-sectional view illustrating an example of the solar cell 30 according to the third embodiment of the invention. In order to make the understanding of the present invention easier, in Fig. 3, the thickness of the p-layer 31, the n-layer 32, and the i-layer 33 is increased. In Fig. 3, the same elements shown in the solar cell 10 are given the same reference numerals as shown in Fig. 1 and the description is not repeated.

As shown in Fig. 3, the solar cell 30 comprises: a p-layer 31; an n-layer 32; an i-layer 33 disposed between the p-layer 31 and the n-layer 32; an antireflective-and-transparent conductive film 13 disposed on the surface of the p-layer 31; a front-face electrodes 14 arranged in a comb-shaped manner on the surface of the antireflective-and-transparent conductive film 13; and a back-face electrode 15 disposed on the back face of the n-layer 32. Inside the p-layer 31 and the n-layer 32, nanoparticles 1, 1, ...are three-dimensionally and homogeneously arranged all over. The p-layer 31 is constituted by a P-type semiconductor; the n-layer 32 is constituted by an N-type semiconductor. Examples of the solar cell 30 having a pin structure include an amorphous Si solar cell.

When a light is irradiated to the solar cell 30, a light of which reflection is inhibited by the antireflective-and-transparent conductive film 13 enters into the p-layer 31, the i-layer 33, and the n-layer 32. The incident light is absorbed in these layers and then carriers are produced. As for the produced carriers, due to the internal electric field generated by the p-layer 31 and the n-layer 32, the electron moves toward back-face electrode 15 and the hole moves toward the front-face electrode 14. In the solar cell 30, nanoparticles 1, 1, ... are arranged in the n-layer 32 and the p-layer 31, but not in the i-layer 33 equivalent to the depletion layer. So, when the light entered into the p-layer 31 and the n-layer 32 reaches the nanoparticles 1, 1, ..., by the localized surface plasmon resonance, the optical electric-field is locally enhanced at the vicinity of the nanoparticles 1, 1, .... In the solar cell 30, since the nanoparticles 1, 1, ... are three-dimensionally and homogeneously arranged inside the p-layer 31 and the n-layer 32, compared with the case where the nanoparticles 1, 1, ... are arranged only on the surface of the p-layer 31 and the n-layer 32, it is possible to enhance the optical electric-field in many regions of both the P-type semiconductor constituting the p-layer 31 and the N-type semiconductor constituting the n-layer 32. When the optical electric-field generated by the light entered into the semiconductor is enhanced, it is possible to produce many carriers in the semiconductor; thereby, it is possible to improve the photoelectric conversion efficiency. Hence, according to the invention, it is possible to provide a solar cell 30 which is capable of improving the photoelectric conversion efficiency.

In the solar cell 30, the nanoparticles 1, 1, ... are not arranged in the depleted i-layer 33, but only arranged in the non-depleted region of the p-layer 31 and the n-layer 32. Therefore, similar to the solar cell 20, it is possible to reduce the moving distance of the carriers before the carriers reach the front-face electrode 14 and the back-face electrode 15 and also possible to prevent the carrier from disappearing by recombination. Hence, according to the invention, even when the i-layer 33 is provided, by arranging the nanoparticles 1, 1, ... in the p-layer 31 and the n-layer 32, it is possible to provide the solar cell 30 which is capable of improving the photoelectric conversion efficiency.

In the solar cell 30, the p-layer 31 may be constituted by the same material as that of the p-layer 11 of the solar cell 10; the thickness of the p-layer 31 (i.e. the upper-and-lower direction of Fig. 3; below, it is the same in this paragraph.) may be 5-20 nm. The n-layer 32 can be constituted by the same material as that of the n-layer 12 of the solar cell 10; the thickness of the n-layer 32 may be 10-30 nm. The thickness of the i-layer 33 may be 400-600 nm.

An example of the method for producing the above solar cell 30 will be described below. To produce the solar cell 30, first of all, in the same manner as the method of producing the solar cell 10, the back-face electrode 15 is formed; then, the n-layer 32 in which the nanoparticles 1, 1, ... are arranged is formed on the surface of the formed back-face electrode 15 in the same manner as the method for forming the n-layer 12 of the solar cell 10. When the formation of the n-layer 32 is completed in this way, for example, by CVD method or MBE method, the i-layer 33 is formed by depositing, on the surface of the n-layer 32, I-type semiconductor which is not doped with p-type impurities or n-type impurities. After forming the i-layer 33, except for using the P-type semiconductor instead of N-type semiconductor, the p-layer 31 in which the nanoparticles 1, 1, ... are arranged is formed in the same manner as the forming method of the n-layer 32. After forming the p-layer 31, the antireflective-and-transparent conductive film 13 is formed on the surface of the p-layer 31 by CVD method or MBE method. By using a known method such as vapor deposition or sputtering method, the front-face electrode 14 is formed on the surface of the antireflective-and-transparent conductive film 13, to produce the solar cell 30.

### 4. The fourth embodiment

Fig. 4 is a cross-sectional view illustrating an example of the solar cell 40 according to the fourth embodiment of the invention. In order to make the understanding of the present invention easier, in Fig. 4, the thickness of the p-layer 31, the n-layer 32, and the i-layer 41 is increased. In Fig. 4, the nanoparticles 1, 1, ... are shown in a simplified manner. In Fig. 4, the same elements shown in the solar cell 30 are given the same reference numerals as shown in Fig. 3 and the description is not repeated.

As shown in Fig. 4, the solar cell 40 comprises: a p-layer 31; an n-layer 32; an i-layer 41 (light-absorbing layer 41) disposed between the p-layer 31 and the n-layer 32; an antireflective-and-transparent conductive film 13 disposed on the surface of the n-layer 32; a front-face electrodes 14 arranged in a comb-shaped manner on the surface of the antireflective-and-transparent conductive film 13; and a back-face electrode 15 disposed on the back face of the p-layer 31. The i-layer 41 comprises: quantum structure portions 42 each having a wet layer 42a and quantum dots 42b, 42b, ... grown on the wet layer 42a; and an interlayer 43 constituted by a semiconductor having a wider band gap than that of the semiconductor constituting the quantum structure portion 42, wherein the quantum structure portions 42 and the interlayer 43 are alternately laminated. In the interlayer 43, the nanoparticles 1, 1, ... are arranged in a region located at a distance of less than or equal to the diameter of the nanoparticle 1 from the quantum dots 42b, 42b, ... (hereinafter, referred to as "quantum dot near-field region".) and a region located at the distance of more than the diameter of the nanoparticle 1 from the quantum dots 42b, 42b, ... (hereinafter, referred to as "quantum dot non-near-field region".) are provided. Moreover, in the solar cell 40, the nanoparticles 1, 1, ... are arranged even inside the quantum dots 42b, 42b, ....

When a light is irradiated to the solar cell 40, a light of which reflection is inhibited by the antireflective-and-transparent conductive film 13 enters into the n-layer 32, the i-layer 41, and the p-layer 31. The incident light is absorbed in these layers and then carriers are produced. As for the produced carriers, due to the internal electric field generated by the p-layer 31 and the n-layer 32, the electrons move toward the front-face electrode 14 and the holes move toward the back-face electrode 15. In the solar cell 40, when a light enters into the i-layer 41, carriers are produced in the quantum structure portions 42, 42, ... and the interlayers 43, 43, .... The carriers produced in the quantum structure portions 42, 42, ... pass through the interlayer 43, 43, by resonant tunneling and reach the front-face electrode 14 or the back-face electrode 15 via the quantum structure portions 42, 42, .... On the other hand, carriers produced in the interlayers 43, 43, ... fall down to the quantum structure portions 42, 42, ... and reach the front-face electrode 14 or the back-face electrode 15 in the same manner as the carriers produced in the quantum structure portions 42, 42, .... As above, in the solar cell 40, the nanoparticles 1, 1, ... are arranged in the quantum dots 42b, 42b, ... (hereinafter, simply referred to as "quantum dot 42b".), the quantum dot near-field region of the interlayer 43, and the quantum dot non-near-field region of the interlayer 43. By arranging the nanoparticle 1 in the quantum dot 42b, it is possible to attain the effect of the localized surface plasmon resonance in the quantum dot 42b; as a result, it is possible to enhance the optical electric-field in the quantum dot 42b. In addition, by providing the nanoparticles 1, 1, ... in the quantum dot near-field region of the interlayer 43, it is possible to attain the effect of the localized surface plasmon resonance in the interlayer 43 and the quantum dot 42b both existing around the nanoparticles 1, 1, .... As a result, it is possible to enhance the optical electric-field in the interlayers 43 and the quantum dots 42b. Moreover, by arranging the nanoparticles 1, 1, ... in the quantum dot non-near-field region of the interlayer 43, it is possible to attain the effect of the localized surface plasmon resonance in the interlayer 43 existing around the nanoparticles 1, 1, ...; as a result, it is possible to enhance the optical electric-field in the interlayer 43 existing around the nanoparticles 1, 1, .... When the optical electric-field is enhanced in the quantum dot 42b, a plurality of electrons and holes can be easily produced in the quantum dot 42b. If a plurality of electrons and holes are produced in the quantum dot 42b, it becomes easy to make the electrons interact each other and to make holes interact each other in the quantum dot 42b. When the optical electric-field is enhanced in the interlayer 43 existing around the nanoparticles 1, 1, ..., it becomes easy to produce a plurality of electrons and holes in the interlayer 43. Since it is assumed that the electrons and holes which have been produced in the interlayer 43 reach the front-face electrode 14 and the back-face electrode 15 through the quantum structure portions 42, 42, ..., by producing a plurality of electrons and holes in the interlayer 43, it becomes easy to make the electrons interact each other and to make holes interact each other in the quantum dot 42b. When making the electrons interact each other in the quantum dot 42b, it is possible to reduce energy loss of the electrons; when making the holes interact each other in the quantum dot 42b, it is possible to reduce energy loss of the holes. Therefore, by arranging the nanoparticles 1, 1, ... in the quantum dot 42b, the quantum dot near-field region, and the quantum dot non-near-field region, it is possible to provide the solar cell 40 which is capable of improving the photoelectric conversion efficiency.

In the solar cell 40, the constituent material for the interlayer 43 may be a semiconductor which is not doped with p-type impurities or n-type impurities, such as GaNAs. The thickness of each interlayers 43, 43, ... (i.e, the height in the upper-and-lower direction of Fig. 4. Below, it is the same.) may be 40 nm. The constituent material for the quantum structure portion 42 may be a semiconductor of which band gap is narrower than the semiconductor constituting the interlayer 43, such as InAs semiconductor which is not doped with p-type impurities or n-type impurities. The thickness of respective wet layers 42a, 42a, ... may be equivalent to a length of about one or two layers of molecule; the height of respective quantum dots 42b, 42b, ... (i.e. the height in the upper-and-lower direction of Fig. 4.) may be 3-10 nm; and the diameter of respective quantum dots 42b, 42b, ... (i.e. the maximum length of the quantum dot 42b in the right-and-left direction.) may be 5-100 nm. The thickness of the i-layer 41 may be, for example, 300 nm to 2µm.

An example of the method for producing the above solar cell 40 will be described below. To produce the solar cell 40, first of all, in the same manner as the method of producing the solar cell 10, the back-face electrode 15 is formed; then, the p-layer 31 in which the nanoparticles 1, 1, ... are arranged is formed on the surface of the formed back-face electrode 15 in the same manner as the method for producing the solar cell 30. When the formation of the p-layer 31 is completed in this way, in same manner as the method for producing the solar cell 10, the nanoparticles 1, 1, ... are arranged on the surface of the p-layer 31.
After arranging the nanoparticles 1, 1, ..., by CVD method or MBE method, the wet layer 42a is formed by depositing, on the surface of the p-layer 31, a semiconductor which is not doped with p-type impurities or n-type impurities (i.e. a semiconductor of which band gap is narrower than that of the semiconductor constituting the interlayer 43.). By continuously depositing the semiconductor, quantum dots 42b, 42b, ... are formed in a Stranski-Krastanov (SK) Growth Mode to attain quantum structure portions 42 each having the wet layer 42a and the quantum dots 42b, 42b, ... are formed on the surface of the p-layer 31. By forming the quantum dots 42b, 42b, ... in this mode, it is assumed that the quantum dots 42b, 42b, ... can be grown with the nanoparticles 1, 1, ... (as the core) arranged on the surface of the p-layer 31; so, it is possible to selectively provide the nanoparticles 1, 1, ... inside the quantum dots 42b, 42b, ....
After forming the quantum structure portion 42 in this way, in the same manner as the method for producing the solar cell 10, nanoparticles 1, 1, ... are arranged on the surface of the quantum structure portion 42. After arranging the nanoparticles 1, 1, ..., by CVD method or MBE method, the interlayer 43 is formed by depositing, on the surface of the quantum structure portion 42 on which the nanoparticles 1, 1, ... are arranged, semiconductor which is not doped with p-type impurities or n-type impurities. By forming the interlayer 43 on the surface of the quantum structure portion 42 in this way, it is possible to arrange the nanoparticles 1, 1, ... inside the interlayer 43 (the quantum dot near-field region and the quantum dot non-near-field region of the interlayer 43).
After forming the interlayer 43, in the same manner as the method for producing the solar cell 10, nanoparticles 1, 1, ... are arranged on the surface of the interlayer 43; then, in the same manner as above, a quantum structure portion 42 is formed on the surface of the interlayer 43 on which the nanoparticles 1, 1, ... are arranged. Later, by repeating a procedures including the steps of: arranging the nanoparticles 1, 1, ... on the surface of the quantum structure portion 42; forming the interlayer 43 on the surface of the quantum structure portion 42 on which the nanoparticles 1, 1, ... are arranged; arranging the nanoparticles 1, 1, ... son the surface of the interlayer 43; and forming the quantum structure portion 42 on the surface of the interlayer 43 on which the nanoparticles 1, 1, ... are arranged, the i-layer 41 is formed on the surface of the p-layer 31.
After forming the i-layer 41, an n-layer 32 in which nanoparticles 1, 1, ... are arranged is formed on the surface of the i-layer 41 in the same manner as the method for producing the solar cell 30. When the formation of the n-layer 32 is completed, the antireflective-and-transparent conductive film 13 is formed on the surface of the n-layer 32 by CVD method or MBE method. By using a known method such as vapor deposition or sputtering method, the front-face electrode 14 is formed on the surface of the antireflective-and-transparent conductive film 13, to produce the solar cell 40.

In the above description regarding the solar cell 40, an embodiment where the nanoparticles 1, 1, ... are arranged inside and around the quantum dot 42b, 42b, ... has been described; however, the present invention is not limited to the embodiment. When the solar cell of the invention (photoelectric conversion device) comprises the quantum dot, the nanoparticle may be arranged only inside the quantum dot; it may be arranged only around the quantum dot. Hereinafter, these modes will be described.

### 5. The fifth embodiment

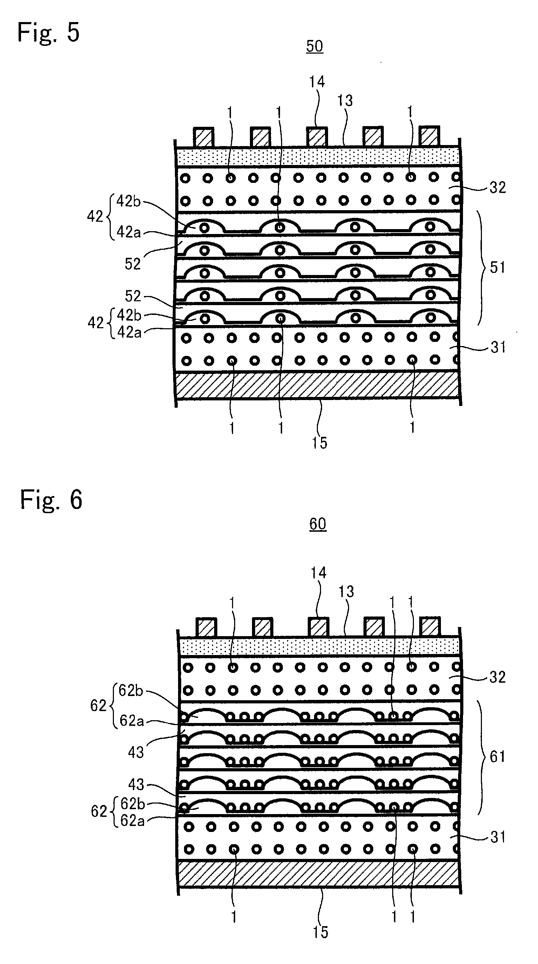

Fig. 5 is a cross-sectional view illustrating an example of the solar cell 50 according to the fifth embodiment of the invention. In order to make the understanding of the present invention easier, in Fig. 5, the thickness of the p-layer 31, the n-layer 32, and the i-layer 51 is increased. In Fig. 5, the nanoparticles 1, 1, ... are shown in a simplified manner. In Fig. 5, the same elements shown in the solar cell 40 are given the same reference numerals as shown in Fig. 4 and the description is not repeated.

As shown in Fig. 5, the solar cell 50 comprises: a p-layer 31; an n-layer 32; an i-layer 51 (light-absorbing layer 51) disposed between the p-layer 31 and the n-layer 32; an antireflective-and-transparent conductive film 13 disposed on the surface of the n-layer 32; a front-face electrodes 14 arranged in a comb-shaped manner on the surface of the antireflective-and-transparent conductive film 13; and a back-face electrode 15 disposed on the back face of the p-layer 31. The i-layer 51 comprises: quantum structure portions 42 each having a wet layer 42a and quantum dots 42b, 42b, ... grown on the wet layer 42a; an interlayer 52 constituted by a semiconductor having a wider band gap than that of the semiconductor constituting the quantum structure portion 42, wherein the quantum structure portions 42 and the interlayer 52 are alternately laminated. In the solar cell 50, the nanoparticles 1 are arranged inside the quantum dots 42b, 42b, ...; while, the nanoparticles 1 are not arranged inside the interlayers 52, 52, ... .

In the solar cell 50, nanoparticles 1 are arranged inside the quantum dots 42b, 42b, .... So, when the light irradiated the solar cell 50 reaches the quantum dot 42b, it is possible to attain the effect of the localized surface plasmon resonance in the quantum dot 42b; as a result, it is possible to enhance the optical electric-field in the quantum dot 42b. By enhancing the optical electric-field in the quantum dot 42b, it is possible to make electrons interact each other in the quantum dot 42b and also possible to make holes interact each other in the quantum dot 42b; thereby, it is possible to reduce the energy loss of the electrons and holes. As a result, it is possible to improve the photoelectric conversion efficiency. Accordingly, even when the nanoparticles 1, 1, ... are arranged only inside the quantum dot 42b, 42b, ..., it is possible to provide the solar cell 50 which is capable of improving the photoelectric conversion efficiency.

In the solar cell 50, the interlayer 52 may be constituted by the same material as that of the interlayer 43 of the solar cell 40; the thickness of the interlayer 52 (i.e. the upper-and-lower direction of Fig. 5) can be the same as that of the interlayer 43. The thickness of the i-layer 51 may be the same as that of the i-layer 41 of the solar cell 40.

An example of the method for producing the above solar cell 50 will be described below. To produce the solar cell 50, first of all, in the same manner as the method of producing the solar cell 10, the back-face electrode 15 is formed; then, the p-layer 31 in which the nanoparticles 1, 1, ... are arranged is formed on the surface of the formed back-face electrode 15 in the same manner as the method for producing the solar cell 30. When the formation of the p-layer 31 is completed in this way, in same manner as the method for producing the solar cell 10, the nanoparticles 1, 1, ... are arranged on the surface of the p-layer 31.
After arranging the nanoparticles 1, 1, ..., in the same manner as the method for producing the solar cell 40, a quantum structure portion 42 is formed on the surface of the p-layer 31 in which the nanoparticles 1, 1, ... are arranged. By forming the quantum structure portion 42 in this way, it is possible to arrange the nanoparticles 1 inside the quantum dots 42b, 42b, .... When the formation of the quantum structure portion 42 is completed, by CVD method or MBE method, an interlayer 52 is formed by depositing, on the surface of the quantum structure portion 42, a semiconductor which is not doped with p-type impurities or n-type impurities.
After forming the interlayer 52 on the surface of the quantum structure portion 42, in the same manner as the method for producing the solar cell 10, the nanoparticles 1, 1, ... are arranged on the surface of the interlayer 52. Later, by repeating a procedure including the steps of: forming the quantum structure portion 42 on the surface of the interlayer 52 (in which the nanoparticles 1, 1, ... are arranged); forming the interlayer 52 on the surface of the quantum structure portion 42; and arranging the nanoparticles 1, 1, ... on the surface of the interlayer 52, the i-layer 51 can be formed on the surface of the p-layer 31.
After forming the i-layer 51, an n-layer 32 in which nanoparticles 1, 1, ... are arranged is formed on the surface of the i-layer 51 in the same manner as the method for producing the solar cell 30. When the formation of the n-layer 32 is completed, the antireflective-and-transparent conductive film 13 is formed on the surface of the n-layer 32 by CVD method or MBE method. Then, by using a known method such as vapor deposition or sputtering method, the front-face electrode 14 is formed on the surface of the antireflective-and-transparent conductive film 13, to produce the solar cell 50.

### The sixth embodiment

Fig. 6 is a cross-sectional view illustrating an example of the solar cell 60 according to the sixth embodiment of the invention. In order to make the understanding of the present invention easier, in Fig. 6, the thickness of the p-layer 31, the n-layer 32, and the i-layer 61 is increased. In Fig. 6, the nanoparticles 1, 1, ... are shown in a simplified manner. In Fig. 6, the same elements shown in the solar cell 40 are given the same reference numerals as shown in Fig. 4 and the description is not repeated.

As shown in Fig. 6, the solar cell 60 comprises: a p-layer 31; an n-layer 32; an i-layer 61 (light-absorbing layer 61) disposed between the p-layer 31 and the n-layer 32; an antireflective-and-transparent conductive film 13 disposed on the surface of the n-layer 32; a front-face electrodes 14 arranged in a comb-shaped manner on the surface of the antireflective-and-transparent conductive film 13; and a back-face electrode 15 disposed on the back face of the p-layer 31. The i-layer 61 comprises: quantum structure portions 62 each having a wet layer 62a and quantum dots 62b, 62b, ... (hereinafter, referred to as simply "quantum dot 62b".) grown on the wet layer 62a; and an interlayer 43 constituted by a semiconductor having a wider band gap than that of the semiconductor constituting the quantum structure portion 62, wherein the quantum structure portions 62 and the interlayer 43 are alternately laminated. In the solar cell 60, inside the interlayers 43, 43, ..., nanoparticles 1, 1, ... are arranged in a quantum dot near-field region and quantum dot non-near-field region; while, nanoparticles 1, 1, ... are not arranged inside the quantum dot 62b, 62b, ....

In the solar cell 60, nanoparticles 1, 1, ... are arranged in the quantum dot near-field region and the quantum dot non-near-field region of the interlayer 43. So, when the light irradiated the solar cell 60 reaches the nanoparticles 1, 1, ... arranged in the quantum dot near-field region of the interlayer 43, it is possible to attain the effect of the localized surface plasmon resonance in the quantum dot 62b and the interlayer 43 existing around the nanoparticles 1, 1, .... As a result, it is possible to enhance the optical electric-field in the quantum dot 62b and the interlayer 43 existing around the nanoparticles 1, 1, ....
When the light irradiated the solar cell 60 reaches the nanoparticles 1, 1, ... arranged in the quantum dot non-near-field region of the interlayer 43, it is possible to attain the effect of the localized surface plasmon resonance in the interlayer 43 existing around the nanoparticles 1, 1, .... As a result, it is possible to enhance the optical electric-field in the interlayer 43 existing around the nanoparticles 1, 1, .... By enhance the optical electric-field in the quantum dot 62b, it becomes easy to make the electrons interact each other and easy to make the holes interact each other in the quantum dot 62b; thereby it is possible to reduce the energy loss of the electron and hole. Hence, it is possible to improve the photoelectric conversion efficiency.
Moreover, by enhancing the optical electric-field in the interlayer 43 existing around the nanoparticles 1, 1, ..., it becomes easy to produce a plurality of electrons and holes in the interlayer 43. It is assumed that the electrons and holes produced in the interlayer 43 reaches the front-face electrode 14 and the back-face electrode 15 via the quantum structure portions 62, 62, .... So, by producing a plurality of the electrons and holes in the interlayer 43, it becomes easy to make the electrons interact each other and easy to make the holes interact each other in the quantum dot 62b. As a result, it is possible to reduce the energy loss of the electrons and holes; thereby it is possible to improve the photoelectric conversion efficiency. Accordingly, even when the nanoparticles 1, 1, ... area arranged only inside the interlayer 43, it is possible to provide the solar cell 60 which is capable of improving the photoelectric conversion efficiency.

In the solar cell 60, the quantum structure portion 62 may be constituted by the same material as that of the quantum structure portion 42 of the solar cell 40; the shape of the quantum structure portion 62 may be the same as that of the quantum structure portion 42. The thickness of the i-layer 61 may be the same as that of the i-layer 41 of the solar cell 40.

An example of the method for producing the above solar cell 60 will be described below. To produce the solar cell 60, first of all, in the same manner as the method of producing the solar cell 10, the back-face electrode 15 is formed; then, the p-layer 31 in which the nanoparticles 1, 1, ... are arranged is formed on the surface of the formed back-face electrode 15 in the same manner as the method for producing the solar cell 30. When the formation of the p-layer 31 is completed in this way, in same manner as the forming method of the quantum structure portion 42 of the solar cell 40, a quantum structure portion 62 is formed on the surface of the p-layer 31.
After forming the quantum structure portion 62, in the same manner as the method for producing the solar cell 10, nanoparticles 1, 1, ... are arranged on the surface of the quantum structure portion 62; then, in the same manner as the method for producing the solar cell 40, an interlayer 43 is formed on the surface of the quantum structure portion 62 in which the nanoparticles 1, 1, ... are arranged. By forming the interlayer 43 on the surface of the quantum structure portion 62, it is possible to arrange the nanoparticles 1, 1, ... inside the interlayer 43 (i.e. the quantum dot near-field region and the quantum dot non-near-field region of the interlayer 43).
When the formation of the interlayer 43 is completed in this way, an i-layer 61 is formed on the surface of the p-layer 31 by repeating a procedure including the steps of: forming the quantum structure portion 62 on the surface of the interlayer 43; arranging the nanoparticles 1, 1, ... on the surface of the quantum structure portion 62; and forming the interlayer 43 on the surface of the quantum structure portion 62 in which the nanoparticles 1, 1, ... are arranged.
After forming the i-layer 61, an n-layer 32 in which nanoparticles 1, 1, ... are arranged is formed on the surface of the i-layer 61 in the same manner as the method for producing the solar cell 30. When the formation of the n-layer 32 is completed, the antireflective-and-transparent conductive film 13 is formed on the surface of the n-layer 32 by CVD method or MBE method. Then, by using a known method such as vapor deposition or sputtering method, the front-face electrode 14 is formed on the surface of the antireflective-and-transparent conductive film 13, to produce the solar cell 60.

In the above description regarding the solar cells 40, 50, 60, embodiments in which the quantum dots are formed on the n-layer side of the wet layer have been shown; however the present invention is not limited to these embodiments. The solar cell (i.e. photoelectric conversion device) of the invention may also have a structure where the p-layer 31 and the n-layer 32 are exchanged in the solar cells 40, 50, 60.

In addition, in the above description regarding the solar cells 40, 50, 60, embodiments provided with the p-layer 31 and the n-layer 32 in each of which the nanoparticles 1, 1, ... are arranged are shown; however, the present invention is not limited to these embodiment. When the quantum structure portion is provided to the solar cell (photoelectric conversion device) of the invention, it may be an embodiment provided with the p-layer and/or the n-layer in each of which the metal nanoparticles are not arranged.

Although the above description of the invention does not states the embodiment that the size of the nanoparticles 1, 1, ... are changed depending on the distance from the light receiving face, in this invention, it is preferable to arrange nanoparticles having relatively a larger diameter in a region located at a longer distance from the light receiving face and to arrange nanoparticles having relatively a smaller diameter in a region located at a shorter distance from the light receiving face. In other words, if a light is irradiated from the upper side of the solar cell in Figs. 1-6, when the diameter of the nanoparticle being arranged in the upper side of each figure is R1 and the diameter of the nanoparticle being arranged in the lower side of each figure is R2, the relation between R1 and R2 is preferably: R1 < R2. In the case where the solar cell is a bifacial solar cell, preferably, nanoparticles having relatively smaller diameter are disposed at the vicinity of the light receiving face and nanoparticles having relatively larger diameter are disposed at a location away from the light receiving face. There is a mutual relation between the wavelength of the optical electric-field enhanced by the localized surface plasmon resonance and the diameter of the metal nanoparticle. The short wavelength optical electric-field tends to be enhanced around the metal nanoparticles having a shorter diameter; the long wavelength optical electric-field tends to be enhanced around the metal nanoparticle having a larger diameter. Therefore, by arranging the metal nanoparticle having relatively a shorter diameter in region near the light receiving face by which a short wavelength light can be easily absorbed, it is possible to provide an embodiment which can easily absorb the short wavelength light. Also, by arranging the metal nanoparticle having relatively a larger diameter in a region away from the light receiving face which can easily absorb a long wavelength light, it is possible to provide an embodiment which can easily absorb the long wavelength light. Accordingly, to provide a photoelectric conversion device which can easily improve the photoelectric conversion efficiency, it is preferable to arrange metal nanoparticles having relatively a larger diameter in a region away from the light receiving face, and it is preferable to arrange metal nanoparticles having relatively a smaller diameter in a region near the light receiving face.

Moreover, in the above description of the invention, an embodiment where the nanoparticle 1 which comprises: a metal nanoparticle 1a; and an insulator 1b coating the surface of the metal nanoparticle 1a are arranged is shown. However, the invention is not limited to the embodiment; the invention may be an embodiment where the metal nanoparticles 1a of which surface is not coated with the insulator are arranged in the semiconductor. It should be noted that since the metal nanoparticle 1a is a conducting substance, when arranging it in the semiconductor of the photoelectric conversion device, the carriers produced by the light irradiation may possibly be captured by the metal nanoparticles 1a during the movement of the carriers. If the carriers are captured by the metal nanoparticle 1a, the number of carriers reaching the electrode decreases, so there is a possibility that the effect of photoelectric conversion efficiency will be deteriorated. So, in the invention, in view of providing an embodiment which is capable of improving photoelectric conversion efficiency, it is preferable to provide, in the semiconductor, nanoparticles comprising the metal nanoparticle and the insulator coating at least a part of the surface of the metal nanoparticle. It is more preferable to provide, in the semiconductor, nanoparticles comprising the metal nanoparticle and the insulator coating the entire surface of the metal nanoparticle.

Further, in the above description of the invention, an embodiment of which quantum structure portion is quantum dot is shown; however, the invention is not limited to this embodiment. The photoelectric conversion device of the invention may be an embodiment where a quantum well or a quantum wire is used as the quantum structure portion. When the invention uses a quantum wire as the quantum structure portion, for example, a solar cell (in which the quantum wire is disposed on the light-absorbing layer so that the axial direction of the quantum wire intersects the electric current/voltage direction in the light-absorbing layer) can be shown by the similar cross-section to those of Figs. 4-6. In the invention, when the quantum wire is used as the quantum structure portion, the structure and material for constituting the quantum wire are not particularly limited; a known quantum wire such as carbon nanotube can be used.

As seen above, a case in which the present invention is applied to a solar cell has been described; however, the application of the photoelectric conversion device of the invention is not limited to the solar cell. The invention can also be applied to other photoelectric conversion devices such as photodetection element.

### Industrial Applicability

The photoelectric conversion device of the present invention can be used for, for example, a power source of electric vehicles and a photovoltaic system.

## Claims

1. A photoelectric conversion device comprising a layer, which comprise a semiconductor and metal nanoparticles disposed inside the semiconductor.

2. The photoelectric conversion device according to claim 1, wherein at least a part of the surface of the metal nanoparticles is coated by an insulator.

3. The photoelectric conversion device according to claim 1 or 2, which comprises: a p-layer; an n-layer; a first electrode connected to the p-layer; and a second electrode connected to the n-layer,
wherein a semiconductor located between the first electrode and a depletion layer formed by connecting the p-layer and the n-layer and/or a semiconductor located between the depletion layer and the second electrode contain a larger number of the metal nanoparticles than the depletion layer itself.

4. A photoelectric conversion device comprising: a quantum structure portion; and a semiconductor layer arranged around the quantum structure portion,
the constituent material of the quantum structure portion comprising the semiconductor, and
the metal nanoparticles being arranged inside the quantum structure portion and/or inside the semiconductor layer.

5. The photoelectric conversion device according to claim 4, wherein at least a part of the surface of the metal nanoparticle is coated by an insulator.

6. The photoelectric conversion device according to claim 4 or 5, wherein the metal nanoparticles are arranged inside the semiconductor layer,
the distance between the quantum structure portion and at least a part of the metal nanoparticles arranged inside the semiconductor layer being less than or equal to the diameter of the metal nanoparticle.

7. The photoelectric conversion device according to any one of claims 1 to 6, wherein when the diameter of the metal nanoparticle being arranged in a region located at a distance of D1 from the light receiving face is R1 and the diameter of the metal nanoparticle being arranged in a region located at a distance of D2 which is longer than D1 from the light receiving face is R2, the relation between R1 and R2 is: R2 > R1.
